# EUROPÄISCHE PATENTSCHRIFT

(11) **EP 1 802 700 B1**
(45) Veröffentlichungstag und Bekanntmachung des Hinweises auf die Patenterteilung: **06.10.2010**
(21) Anmeldenummer: 05800250.2
(22) Anmeldetag: 13.10.2005
(51) Int. Cl.: C08L 33/06, C08L 75/16, A61L 27/16, G03F 7/00, B29C 67/00

(54) **NIEDRIGVISKOSE, STRAHLUNGSHÄRTBARE FORMULIERUNG ZUR HERSTELLUNG VON OHRPASSSTÜCKEN**
LOW-VISCOSITY, RADIATION-CURABLE FORMULATION FOR PRODUCING ADAPTIVE EAR PIECES
FORMULATION PEU VISQUEUSE DURCISSABLE PAR RAYONNEMENT POUR LA PRODUCTION D'EMBOUTS D'AIDES AUDITIVES

(30) Priorität: 18.10.2004 DE 102004050868
(43) Veröffentlichungstag der Anmeldung: 04.07.2007
(73) Patentinhaber: Dreve Otoplastik GmbH, 59423 Unna (DE)
(72) Erfinder: KLARE, Martin, 44227 Dortmund (DE); ALTMANN, Reiner, 44575 Castrop-Rauxel (DE); KUTSCHINSKI, Michael, 44579 Castrop-Rauxel (DE); VEIT, Thomas, 48151 Münster (DE)
(74) Vertreter: Köchling, Conrad-Joachim
(86) Internationale Anmeldenummer: PCT/DE2005/001836
(87) Internationale Veröffentlichungsnummer: WO 2006/042514

(56) Entgegenhaltungen:
- EP-A- 0 425 441
- EP-A- 0 831 372
- WO-A-2005/001570
- DE-A1- 19 848 886

## Beschreibung

Die Erfindung betrifft niedrigviskose, strahlungshärtbare Formulierungen zur Herstellung von medizintechnischen Produkten, insbesondere zur Herstellung von Ohrpassstücken, die mittels des PNP-Verfahrens (U. Voogdt, "Otoplastik" 2 Aufl., Bd.2, Median-Verlag von Killisch-Horn GmbH, S.22 ff (1998)) oder eines regenerativen Verfahrens wie z.B. der Stereolithographie hergestellt werden, auf Basis mindestens zweier Verbindungen, die radikalisch polymerisierbare (Meth)acrylatfunktionen aufweisen, und mindestens eines für die Polymerisation der geeigneten Verbindungen geeigneten Photoinitiators, und mindestens eines für die Stabilisierung der Formulierungen bestimmten Inhibitors, und mindestens des einen Iminooxadiazondionderivates, charakterisiert durch 3 Methacrylat- und/oder Acrylatfunktionen, das für die Vernetzung der neben anderen schon in der Technik bekannten Vernetzermono- /oligomeren als eine sehr vorteilhafte Formulierungskomponente für solchartige Zusammensetzungen geeignet ist.

Beim so bezeichneten PNP-Verfahren (Positiv-Negativ-Positiv) nimmt der Hörgeräteakustiker in einem ersten Schritt einen Ohrabdruck (Positiv) zur Herstellung einer Otoplastik (für hinter dem Ohr getragene Geräte) oder einer Schale (für im Ohr getragene Geräte). In einem zweiten Schritt wird mittels der Abformung eine Negativform (N) angefertigt, in die nachfolgend die strahlungshärtbare, niedrigviskose Formulierung gegossen und daraufhin belichtet wird. Das so gefertigte Ohrpassstück (Positiv) muss dem Gehörgang optimal angepasst sein. Andernfalls würden ungenaue Passstücke Beschwerden (z.B. Druckstellen) verursachen und die Funktion von Hörgeräten (z. B. Rückkopplungen) beeinträchtigen. Demzufolge ist es wichtig, dass die Formulierung möglichst niedrigviskos d. h. "gut fließend" ist, so dass auch Unterschnitte und feinste Oberflächentexturen vom Material ausgefüllt und so abgebildet werden können.

Es ist aus US. Pat. 4,575,330 bekannt, dass niedrigviskose, strahlungshärtbare Harze bzw. Harzgemische für die Herstellung von dreidimensionalen Objekten mittels Stereolithographie eingesetzt werden können. Ferner ist aus US. Pat. 5,487,012 und WO 01/87001 bekannt, dass die Stereolithographie vorteilhaft zur Herstellung von Ohrstücken eingesetzt werden kann. Beim stereolithographischen Verfahren werden dreidimensionale Objekte aus einer niedrigviskosen, strahlungshärtbaren Formulierung in der Weise aufgebaut, dass jeweils eine dünne Schicht (ca. 0,0025-0,1 mm) der Formulierung mittels aktinischer Strahlung in definierter Weise so vorhärtet, dass die erzeugte Schicht die gewünschte Querschnittsform des Objektes an dieser Stelle vorweist. Zeitgleich wird die erzeugte Schicht an die im Schritt zuvor gehärtete Schicht polymerisiert. Der Aufbau des Gesamtobjektes lässt sich so mit Hilfe eines computergesteuerten Lasersystems wie z.B. eines Nd:YVO4 Festkörperlasers (Viper si2 SLA System, Fa. 3D Systems, USA) bewerkstelligen. Der generierte Formkörper wird gegebenenfalls, z.B. durch Strahlung, nachgehärtet.

An die im stereolithographischen Prozess einsetzbaren Harzformulierungen werden besondere Anforderungen gestellt. Dabei sind insbesondere die Strahlungsempfindlichkeit und die Viskosität der Harzformulierungen, sowie die Festigkeit der mittels Laserhärtung vorgehärteten Formkörper zu nennen. Dieser nicht völlig gehärtete Formkörper wird in der

Technik der Stereolithographie als Grünling bezeichnet, und die Festigkeit dieses Grünlings, charakterisiert durch den E-Modul und die Biegefestigkeit, bezeichnet man als Grünfestigkeit. Die Grünfestigkeit stellt für die Praxis der Stereolithographie einen wichtigen Parameter dar, da Formkörper mit geringer Grünfestigkeit sich während des Stereolithographieprozesses unter ihrem eigenen Gewicht deformieren oder während der Nachhärtung, beispielsweise mit einer Xenonbogen- oder Halogenlampe, absacken oder sich durchbiegen können. Es ist daher verständlich, dass unter Berücksichtigung der oben genanten Anforderungen kompliziert abgestimmte und formulierte Zusammensetzungen eingesetzt werden. Beispielsweise wird von H. Kodama in Rev. Sci. Instrum. 52 (11), 1170-1173 (1981) eine niedrigviskose, strahlungshärtbare Harzformulierung offenbart, die aus einem ungesättigten Polyester, einem Acrylsäureester, Styrol und einem Polymerisationsinitiator besteht. Im Hinblick auf den Einsatz in der Stereolithographietechnik weist diese Harzformulierung jedoch eine geringe Grünfestigkeit und eine ungenügende Photoempfindlichkeit auf.

Eine ebenfalls unter produktionstechnischen Gesichtspunkten ungenügende Photoempfindlichkeit weisen die in US. Pat. 4,100,141 offenbarten Harzformulierungen auf. Dabei bedeutet eine geringe Photoempfindlichkeit, dass lange Zeiten für die Herstellung der Formkörper benötigt werden. Dementsprechend muss die Photoempfindlichkeit der Stereolithographieharzformulierungen so eingestellt sein, dass sich aus dem Verhältnis von erzielter Eindringtiefe des Laserstrahles in die niedrigviskose, strahlungshärtbare Harzformulierung und der aufgewandten Strahlungsenergie ergibt, dass mit geringer Strahlungsenergie eine möglichst große Härtungstiefe bei gleichzeitig hohem Polymerisationsgrad, guter Grünfestigkeit und ausreichender Stabilität der Harzformulierung gegen Autopolymerisation realisiert werden. Flüssige, strahlungshärtbare Harzformulierungen die den o. g. Anforderungen teilweise genügen sind beispielsweise in US. Pat. 5,476,748 oder in WO 99/50711 beschrieben. Diese als "Hybrid-System" bezeichneten Formulierungen enthalten allerdings eine Kombination aus radikalisch und kationisch polymerisierbaren Komponenten. Sie bestehen erstens aus einer flüssigen, di- bzw. polyfunktionellen Epoxyverbindung oder aus einer Mischung, bestehend aus difunktionellen oder höherfunktionellen Epoxyverbindungen; zweitens aus einem kationischem Photoinitiator bzw. aus einer Mischung von kationischen Photoinitiatoren; drittens aus einem Photoinitiator bzw. aus einer Mischung von Photoinitiatoren für die freie radikalische Polymerisation und mindestens aus einem niedrigviskosen Poly(meth)acrylat mit einer (Meth)acrylatfunktionalität von n>2, mindestens einem Diacrylat und einer Polyolkomponente aus der Gruppe hydroxylterminierter Polyether, Polyester und Polyurethane. Dem Fachmann ist bekannt, dass solche Formulierungen unter toxikologischen Aspekten kritisch zu bewerten sind und demzufolge nicht oder nur eingeschränkt zur Herstellung von Medizinprodukten eingesetzt werden können. Beispielsweise ist bekannt, dass kationische Photoinitiatoren zu Hautreizungen und allergischen Reaktionen führen können. Ähnliches gilt für die in solchen Formulierungen eingesetzten Verbindungen mit Epoxidfunktionen. Es ist dem Fachmann ferner bekannt, dass viele Acrylatverbindungen -insbesondere kurzkettigeebenfalls ein erhöhtes Allergiepotential besitzen und somit Harzzusammensetzungen, wie sie z.B. in EP 0425441, EP 0914242 und EP 0579503 beschrieben sind, unter Biokompatibilitätsaspekten nicht zur Herstellung von z.B. Ohrstücken verwendet werden können. Für den Einsatz in der Medizintechnik haben sich monomere oder oligomere Dimethacrylate auf Basis von Bisphenol A oder Bisphenol F und Urethanmethacrylate mit einer Funktionalität von n ≥ 2 bewährt. Im Vergleich zur Gruppe der Acrylatverbindungen weist für die Technik der Stereolithographie die Gruppe der Methacrylatverbindungen jedoch eine geringere Reaktivität auf. Daraus ergeben sich die schon o. g. Nachteile hinsichtlich Eindringtiefe des Laserstrahles und Grünfestigkeit der vorgehärteten Objekte. Darüber hinaus sind aufgrund der verminderten Reaktivität dieser Verbindungsklasse höhere Konzentrationen an einem oder mehreren Photoinitiatoren für die freie radikalische Polymerisation einzusetzen. Daraus resultiert eine verringerte Stabilität gegen Autopolymerisation der Harzformulierung. Dem Fachmann ist weiterhin bekannt, dass in der Technik der Stereolithographie bei der Herstellung einer großen Anzahl kleinteiliger Objekte von geringer Masse eine erhöhte mechanische und thermische Belastung der Stereolithographieharzformulierung vorliegt, die zu einer Autopolymerisation des Stereolithographieharzes bzw. zu sich verändernden Eigenschaften der Harzzusammensetzung und der daraus generierten Formkörper führen kann. Dies ist zum einen darauf zurückzuführen, dass bei geringem Harzverbrauch die auf einer Plattform fixierten, vorgehärteten Formkörper relativ häufig aus dem Bauraum der Stereolithographieanlage entfernt werden müssen. Daraus resultieren Temperaturschwankungen des Stereolithographieharzes im Bauraum. Zum anderen ergibt sich bei der Produktion von Ohrstücken ein relativ großes Oberflächen- zu Volumenverhältnis der generierten Formkörper. Es ist dem Fachmann bekannt, dass bei der freien radikalischen Polymerisation infolge von Sauerstoffzutritt eine Inhibierungsschicht an der Oberfläche der Formkörper zurückbleibt. Das nur unvollständig an- bzw. auspolymerisierte Harz kann sich so während des Bauprozesses von der Oberfläche des Probenkörpers in das Stereolithographieharz lösen.

Ein weiterer wichtiger Punkt für solche Formulierung ist die Flexibilität der erhaltenen Formkörper. Dem Fachmann ist bekannt, dass die kommerziell erhältlichen Formulierungen, die für die o.g. Anwendungen ausreichende Biokompatibilität aufweisen, spröde sind. Die durchschnittlichen Dehnungswerte für ausgehärtete Objekte liegen zwischen 4-8% (DIN EN ISO 178). Bei erhöhter mechanischer Belastung kann es so zu einem Bruch der generierten Ohrpassstücke kommen, der zu scharfkantigen Bruchteilen führen kann. Dies ist im Hinblick auf eine erhöhte Verletzungsgefahr unerwünscht. Zur Lösung dieser Problematik sind verschiedene Strategien, wie der Einsatz monofunktioneller Verdünnermonomere (JP 97-431498) oder der Einsatz von monomeren bzw. oligomeren, niedrigviskosen Urethanacrylaten (DE 4,138,309) verfolgt worden. Durch Einsatz der genannten Komponenten können Werkstoffe mit erhöhter Flexibilität realisiert werden. Allerdings ergeben sich durch die o.g. Formulierungskomponenten Nachteile wie ein erhöhter Schrumpf, eine erhöhte

Wasseraufnahme und durch niedrigviskose Urethanacrylate ein erhöhtes allergiesierendes Potential. Darüber hinaus ist der Einsatz von Polyetherpolyolen (WO 97/38354) zur Erniedrigung der Vernetzungdichte des 3-dimensionalen Polymernetzwerkes beschrieben, um die Sprödigkeit von Formkörpern zu erniedrigen. Zu den Nachteilen dieser Methode zählen aber ein Verlust an Festigkeit und eine wesentliche Verringerung der Wasser- und Feuchtigkeitsstabilität der generierten Formkörper.

Aus diesen Punkten ist ersichtlich, dass bei der Herstellung von Ohrstücken mittels des PNP-Verfahrens und der stereolithographischen Technik die Minimierung der Viskosität der strahlungshärtbaren Harzzusammensetzung unter Beibehaltung von Biokompatibilität und akzeptabler chemisch-physikalischer, sowie mechanischer Eigenschaften der generierten Formkörper, ein bedeutender Parameter ist. Unter produktionstechnischen Gesichtspunkten mittels Stereolithographie ist es weiterhin wünschenswert, dass sowohl die Eindringtiefe des Laserstrahles und die kritische Energie der Stereolithographieharzformulierung der Anwendung entsprechend eingestellt werden kann.

Aufgabe der vorliegenden Erfindung ist es, eine Harzformulierung für die Produktion von Medizinprodukten, insbesondere von Ohrstücken mittels konventioneller PNP-Technik bzw. mittels Stereolithographie, zur Verfügung zu stellen, die sowohl die mechanischen, insbesondere eine Dehnung von > 10%, toxikologischen als auch die an die o.g. Verfahren gestellten Anforderungen erfüllt. Es wurde nun gefunden, dass ein niedrigviskoses, aus einem oder mehreren voneinander verschiedenen monomeren oder oligomeren Dimethacrylaten auf Basis von Bisphenol A oder Bisphenol F bestehendes Harzgemisch, das außerdem ein Urethan(meth)acrylat mit einer Funktionalität von n < 4 und einer Viskosität >7 und < 20 Pa s, weiterhin ein Iminooxadiazindionderivat mit einer Funktionalität von 3 enthält, für die Technik des PNP-Verfahrens oder der Stereolithographie eingesetzt werden kann und das bei der Härtung mittels Lasers vorgehärtete Formkörper ergibt, die sich durch eine hohe Grünfestigkeit auszeichnen. Überraschenderweise wurde weiter gefunden, dass mit dem Umsetzungsprodukt eines asymmetrischen Isocyanattrimers (AST) mit einem hydroxyfunktionellen (Meth)acrylat im Vergleich zur symmetrischen Variante niedrigviskosere Harzformulierungen herstellbar sind. Ferner sind mit der Kombination aus der o.g. asymmetrischen Variante mit einem aliphatischen Urethan(meth)acrylat strahlungshärtbare, niedrigviskose Harzformulierungen realisierbar, deren Biokompatibilität, deren chemischphysikalischen Eigenschaften und deren Verhältnis von kritischer Energie zur Eindringtiefe des Laserstrahles den Anforderungen der o. g. Herstellverfahren in besonderer Weise gerecht werden können. Darüber hinaus wurde gefunden, dass durch geringen Zusatz eines anaeroben Inhibitors wie Phenothiazin oder DPPH die Lasereindringtiefe und die kritische Energie der Harzformulierungen vorteilhaft gesteuert werden können. Die durch Aushärtung erhaltenen Formkörper weisen neben guten mechanischen Eigenschaften exzellente Biokompatibilität und geringe Wasseraufnahmen auf, besitzen Bruchdehnungswerte ≥10 % und können nachbehandelt wie beispielsweise geschliffen oder lackiert werden. Der Gegenstand der vorliegenden Erfindung ist dementsprechend eine niedrigviskose, strahlungshärtbare Harzformulierung für den Einsatz in der PNP-Technik bzw. der Stereolithographie, enthaltend
a) 15-60 Gew.-% eines monomeren oder oligomeren Dimethacrylats auf Basis von Bisphenol A oder Bisphenol F
b) 0-50 Gew.-% eines oder mehrerer monomerer/oligomerer Urethan(meth)acrylate mit einer Funktionalität von n < 4, einer Viskosität < 30 Pa s und einem Molekülgewicht < 3500
c) 2-25 Gew.-% eines monomeren aliphatischen oder cycloaliphatischen Dimethacrylats mit einer Viskosität < 3 Pa s
d) 2-35 Gew.-% eines Iminooxadiazondionderivates, charakterisiert durch 3 Methacrylat- und/oder Acrylatfunktionen
e) 0-15 Gew.-% eines oder mehrer monofunktioneller Methacrylate
f) 0,5-6 Gew.-% eines oder einer Kombination mehrerer Photoinitiatoren, deren Absorption im Wellenlängenbereich des eingesetzten Laserstrahles bzw. der Bestrahlungsquelle liegt
g) 0 -0,5 Gew.-% eines oder mehrerer anaerober Inhibitoren
h) 0-40 Gew.-% an Füllstoffen
i) 0-5 Gew.-% an Farbmitteln
j) 0-5 Gew.-% an üblichen Additiven wie UV-Stabilisatoren oder Verlaufsadditiven, wobei der Anteil der Komponenten a) bis j) zusammen 100 Gew.-% beträgt.

Vorzugsweise enthält das erfindungsgemäße Gemisch
a) 20-50 Gew.-% eines n-fach ethoxylierten Bisphenol-A-Dimethacrylats mit einem Ethoxylierungsgrad von n < 10 oder eine Mischung n-fach ethoxylierter Bisphenol-A-Dimethacrylate mit einem Ethoxylierungsgrad von n < 10
b) 5-45 Gew.-% eines oder mehrerer aliphatischer oder cycloaliphatischer monomerer/oligomerer Urethan(meth)acrylate mit einer Funktionalität von n < 4, einer Viskosität < 15 Pa s und einem Molekülgewicht < 2000
c) 3-10 Gew.-% eines monomeren aliphatischen oder cycloaliphatischen Dimethacrylats mit einer Viskosität < 3 Pa s
d) 3-25 Gew.-% eines Iminooxadiazondionderivates, charakterisiert durch 3 Methacrylat- und/oder Acrylatfunktionen
e) 2-15 Gew.-% eines oder mehrer monofunktioneller Methacrylate mit einer Viskosität < 3 Pa s
f) 1-4 Gew.-% eines oder einer Kombination mehrerer Photoinitiatoren, deren Absorption im Wellenlängenbereich des eingesetzten Laserstrahles bzw. der Bestrahlungsquelle liegt
g) 0-0,5 Gew.-% eines oder einer Kombination von anaeroben Inhibitoren, auch in Verbindung mit denen, dem Stereolithographiefachmann bekannten aeroben Inhibitoren
h) 0-20 Gew.-% an Füllstoffen
i) 0-5 Gew.-% an Farbmitteln
j) 0,01-3 Gew.-% an üblichen Additiven wie UV-Stabilisatoren oder Verlaufsadditiven, wobei der Anteil der Komponenten a) bis j) zusammen 100 Gew.-% beträgt.

Als Verbindungen der Komponente (a) eignen sich beispielsweise Dimethacrylate des (n)-alkoxylierten Bisphenol A wie Bisphenol-A-ethoxylat(2)dimethacrylat, Bisphenol-A-ethoxylat(4)dimethacrylat, Bisphenol-A-propoxylat(2)dimethacrylat, Bisphenol-A-propoxylat(4)dimethacrylat sowie Dimethacrylate des (n)-alkoxylierten Bisphenol F wie Bisphenol-F-ethoxylat(2)dimethacrylat und Bisphenol-F-ethoxylat(4)dimethacrylat , Bisphenol-F-propoxylat(2)dimethacrylat, Bisphenol-F-propoxylat(4)dimethacrylat und Mischungen dieser. Vorzugsweise verwendet man monomere oder oligomere Dimethacrylate auf Basis von Bisphenol A, insbesondere das Bisphenol-A-ethoxylat(2)dimethacrylat und das Bisphenol-A-ethoxylat(4)dimethacrylat. Besonders bevorzugt sind dabei Mischungen dieser beiden Dimethacrylate auf Bisphenol-A-Basis, mit einem Anteil an Bisphenol-A-ethoxylat(4)dimethacrylat > Bisphenol-A-ethoxylat(2)dimethacrylat.

Die in den erfindungsgemäßen Formulierungen als Komponente (b) eingesetzten Urethan(meth)acrylate mit einer Funktionalität < 4 sind dem Fachmann bekannt und können in bekannter Weise hergestellt werden, indem man beispielsweise ein hydroxylterminiertes Polyurethan mit Methacrylsäure zum entsprechendem Urethanmethacrylat umsetzt, oder indem man ein isocyanatterminiertes Präpolymer mit Hydroxymethacrylaten umsetzt. Entsprechende Verfahren sind z.B. aus EP 0579503 bekannt. Urethan(meth)acrylate sind auch im Handel erhältlich und werden beispielsweise unter der Bezeichnung PC-Cure® von der Firma Piccadilly Chemicals, unter der Produktbezeichnung CN 1963 von der Firma Sartomer, unter der Bezeichnung Photomer von der Firma Cognis, unter der Bezeichnung Ebecryl von der Firma UCB und unter der Bezeichnung Genomer® von der Firma Rahn vertrieben. Bevorzugt werden als Urethan(meth)acrylate solche eingesetzt, die n < 4 funktionalisiert sind, Viskositäten <15 Pa s besitzen, ein Molekülgewicht < 2000 haben, und aus aliphatischen Edukten hergestellt worden sind. Insbesondere findet das aus HEMA und TMDI erhaltene Isomerengemisch 7,7,9- (bzw. 7,9,9-)Trimethyl-4,13-dioxo-3,14-dioxa-5,12-diazahexadecan-1,16-diol-dimethacrylat Anwendung.

Als Verbindungen der Komponente (c) können beispielsweise eingesetzt werden:1,3-Butandioldimethacrylat, 1,6-Hexandioldimethacrylat, 1,3-Butylenglykoldimethacrylat, Diethylenglykoldimethacrylat, Ethylenglykoldimethacrylat, Neopentyldimethacrylat, Polyethylenglykoldimethacrylat, Triethylenglykoldimethacrylat und Tetraethylenglykoldimethacrylat und bevorzugt 1,4-Butandioldimethacrylat. Solche Produkte sind im Handel erhältlich, beispielsweise von der Firma Sartomer.

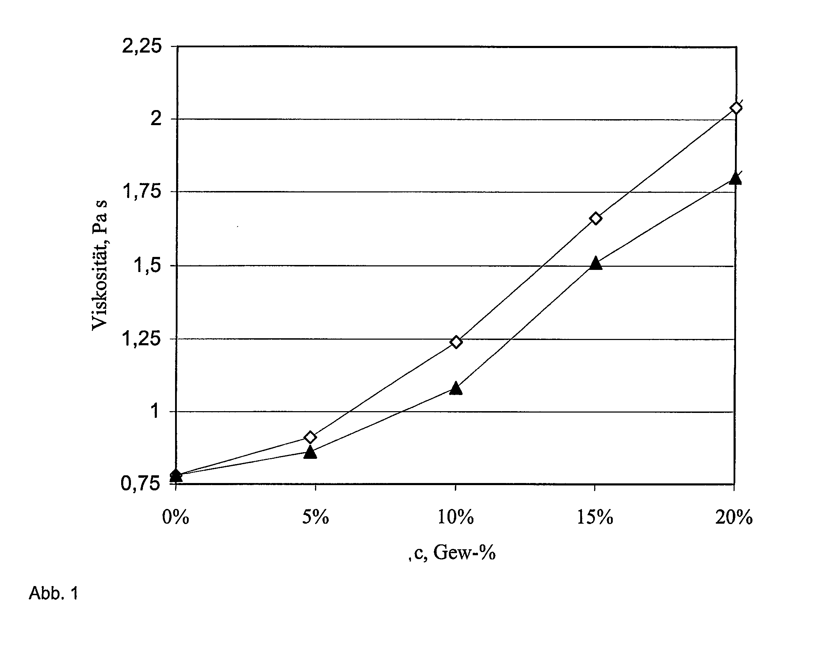

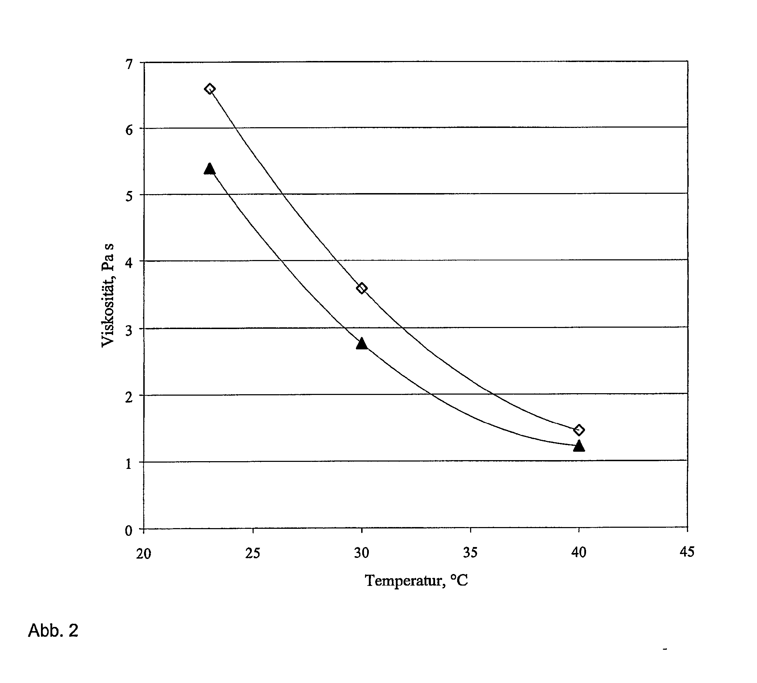

Als Verbindung der Komponente (d) können beispielsweise das Umsetzungsprodukt eines asymmetrisch trimerisierten, aliphatischen Isocyanates mit einem hydroxylgruppenhaltigen Methacrylat, beispielsweise dem 2-Hydroxyethylmethacrylat eingesetzt werden. Solche Produkte sind im Handel erhältlich, beispielsweise von der Firma Rahn. Die asymmetrischen Varianten zeichnen sich durch eine geringere Viskosität im Verhältnis zu den symmetrischen Varianten aus. Die Viskositätsunterschiede zwischen der symmetrischen und asymmetrischen Variante des Umsetzungsproduktes eines HDI-Trimerisates mit 2-Hydroxyethylmethacrylat in der Harzformulierung aus Beispiel 1 sind in Abb.1 und in Abb.2 aufgeführt. Man erkennt deutlich, dass das Iminoxadiazindionderivat im Vergleich zur symmetrischen Variante eine signifikant niedrigere Viskosität besitzt. Die Viskositätsunterschiede zwischen den Varianten werden darüber hinaus mit zunehmender Temperatur größer. Für den Einsatz in Harzformulierungen, die im PNP-Verfahren und in stereolithographischen Verfahren genutzt werden, ist zum einen aus schon o.g. Gründen der Formkörperpräzision eine möglichst niedrige Viskosität anzustreben. Darüber hinaus ist die Bauzeit eines Formkörpers im stereolithographischen Prozess u. a. von der Wischergeschwindigkeit abhängig. Die Wischergeschwindigkeit erhöht sich mit abnehmender Viskosität. Im Hinblick auf möglichst kurze Bauzeiten und demzufolge hohe Wirtschaftlichkeit des Stereolithographieverfahrens ist dementsprechend eine niedrige Viskosität vorteilhaft.

### Beispiel 1:

| | |
|---|---|
| 29,1*(1-x/100) Gew.-% | aliphatisches Urethanacrylatoligomer (Viskosität < 15 Pa s und Molekülgewicht >1500) |
| 28,8*(1-x/100) Gew.-% | Bisphenol-A-ethoxylat(4)dimethacrylat |
| 13,6 *(1-x/100) Gew.-% | aliphatisches Urethantriacrylat |
| 11,2 *(1-x/100) Gew.-% | Bisphenol-A-ethoxylat(2)dimethacrylat |
| 6,1 *(1-x/100) Gew.-% | Tetrahydrofurfurylmethacrylat |
| 6,1 *(1-x/100) Gew.-% | Triethylenglykoldimethacrylat |
| x Gew.-% | Asymmetrische bzw. symmetrische Variante des Umsetzungsproduktes von 2-Hydroxyethylmethacrylat mit dem symmetrischen bzw. asymmetrischen HDI-Trimerisat |
| 3,5 *(1-x/100) Ges.-% | 7,7,9-(bzw.7,9,9-)Trimethyl-4,13-dioxo-3,14-dioxa-5,12diaza-hexadecan-1,16-diol-dimethacrylat |
| 1,2 *(1-x/100) Gew.-% | 2,4,6-Trimethylbenzoyldiphenyl-phosphinoxid |
| 0,4 *(1-x/100) Gew.-% | Bis(2,4,6-trimethylbenzoyl)-phenylphosphinoxid |

In Abbildung 1 ist die Abhängigkeit der Viskosität einer Stereolithographieharzmischung mit symmetrischer Variante (◊) und asymmetrischer Variante (▲) des Umsetzungsproduktes von HEMA mit dem HDI- Trimerisat von der Konzentration des Umsetzungsproduktes gezeigt. In Abbildung 2 ist die Abhängigkeit der Viskosität einer Stereolithographieharzmischung mit 30 Gew. % an symmetrischer Variante (◊) und asymmetrischer Variante (▲) des Umsetzungsproduktes von HEMA mit dem HDI-Trimerisat in Abhängigkeit von der Temperatur gezeigt.

In den erfindungsgemäßen Formulierungen können als Komponente (e) beispielsweise folgende Verbindungen enthalten sein: Allylmethacrylat, Methyl-, Ethyl-, n-Propyl-, n-Butyl-, Isobutyl-, n-Hexyl-, 2-Ethylhexyl-, n-Octyl-, n-Decyl- , n-Dodecyl-, Isobornyl-, Isodecyl-, Lauryl-, Stearylmethacrylat, 2-Hydroxyethyl-, 2- und 3-Hydroxypropylmethacrylat, Tetrahydrofurfurylmethacrylat und Cyclohexylmethacrylat. Besonders bevorzugt ist dabei das Tetrahydrofurfurylmethacrylat.

Als Komponente (f) können als Photoinitiatoren alle Typen eingesetzt werden, die bei der entsprechenden Bestrahlung freie Radikale bilden. Dabei sind bekannte Photoinitiatoren Verbindungen der Benzoine, Benzoinether, wie Benzoin, Benzoinmethylether, Benzoinethylether und Benzoinisopropylether, Benzoinphenylether und Benzoinacetat, Acetophenone, wie Acetophenon, 2,2-Dimethoxyacetophenon, und 1,1-Dichloracetophenon, Benzil, Benzilketale, wie Benzildimethylketal und Benzildiethylketal, Anthrachinone, wie 2-Methylanthrachinon, 2-Ethylanthrachinon, 2-tert.-Butylanthrachinon, 1-Chloranthrachinon und 2-Amylanthrachinon, Triphenylphosphin, Benzoylphosphinoxide, wie beispielsweise 2,4,6-Trimethylbenzoyldiphenylphosphinoxid (Luzirin TPO) und Bis(2,4,6-trimethylbenzoylphenyl)-phosphinoxid, Benzophenone, wie Benzophenon und 4,4'-Bis-(N,N'-dimethylamino)-benzophenon, Thioxanthone und Xanthone, Acridinderivate, Phenazinderivate, Quinoxalinderivate oder 1-Phenyl-1,2-propandion-2-O-benzoyloxim, 1-Aminophenylketone oder 1-Hydroxyphenylketone, wie 1-Hydroxycyclohexylphenylketon, Phenyl-(1-hydroxyisopropyl)-keton und 4-Isopropylphenyl-(1-hydroxyisopropyl)-keton. Besonders bevorzugte Verbindungen, die in Kombination mit einem Nd:YVO4-Festkörperlaser eingesetzt werden, sind Bis(2,4,6-trimethylbenzoyl)-phenylphosphinoxid, 2,4,6-Trimethylbenzoyldiphenylphosphinoxid, 2-Hydroxy-2-methylpropiophenon, Hydroxy-cyclohexylphenylketon und Mischungen dieser Photoinitiatoren.

In den erfindungsgemäßen Gemischen können als anaerobe Inhibitoren bzw. Stabilisatoren das Phenothiazin (PTZ), das 2,2-Diphenyl-1-picrylhydrazyl-radikal (DPPH) oder eine Kombination der Inhibitoren zur Einstellung der Lasereindringtiefe und der kritischen Energie zugesetzt werden.

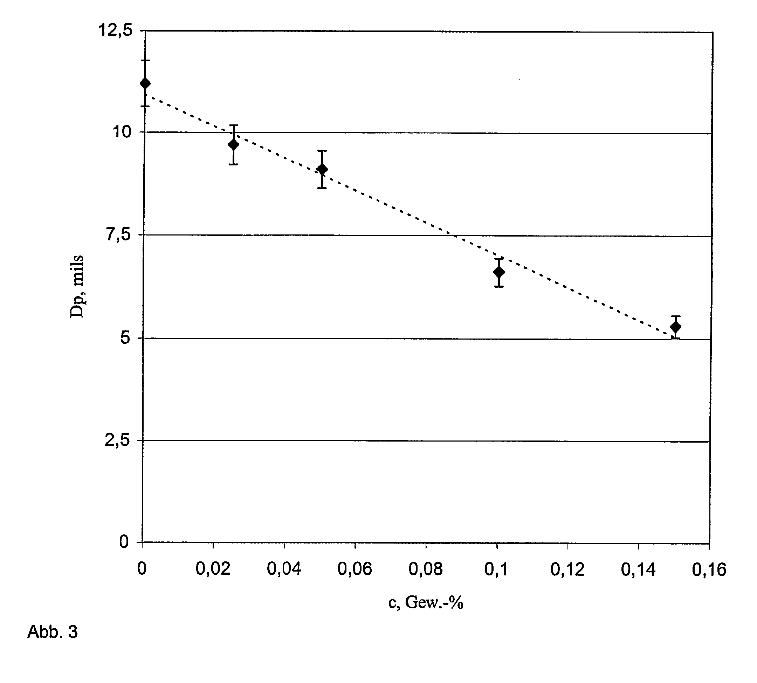

Der Einfluss der Konzentration an Phenothiazin (PTZ) und 2,2-Diphenyl-1-picrylhydrazyl-radikal (DPPH) in den Beispielformulierungen 1 und 2 auf die Eindringtiefe des Laserstrahls und die kritische Energie ist in den Abb. 3 bis 6 dargestellt. Die Lasereindringtiefe und die kritische Energie wurde mittels der Windowpane-Methode, beschrieben von P. F. Jacobs und D. T. Reid in Rapid Prototyping & Manufacturing, Society of Manufacturing Engineers, Dearborn, MI, 1992, 1st. ed., S. 263-280, bestimmt. Man kann den Abbildungen entnehmen, dass schon geringe Zugaben an Phenothiazin (PTZ) und 2,2-Diphenyl-1-picrylhydrazyl-radikal (DPPH) zu einem starken, nahezu linearem Anstieg der kritischen Energie und einer linearen Verringerung der Eindringtiefe des Laserstrahles führen. Dieser Einfluss der Inhibitoren Phenothiazin (PTZ) und 2,2-Diphenyl-1-picrylhydrazyl-radikal (DPPH) auf die relevanten Parameter Ec (kritische Energie, mJ cm-2) und Dp (Lasereindringtiefe, mils) des Stereolithographieharzes unterscheiden sich vom Einfluss der Inhibitoren wie z.B. p-Methoxyphenol, die denen dem Stand der Technik entsprechenden Stereolithographieharzen zugefügt sind (L.B. Levy, J. Polym. Sci., Part A, Polym. Chem. 30 (1992) 569 ff). Beispielsweise lassen sich im Vergleich zum p-Methoxyphenol die Parameter Ec und Dp in einem weiteren Bereich durch geringe Konzentrationen der Inhibitoren linear einstellen. Dies ist insbesondere bei der Produktion solcher Harze und der

Einstellung der o. g. Parameter von großem Vorteil. Dementsprechend kann es so zu einer unter produktionstechnischen Gesichtspunkten relevanten Einstellung der Lasereindringtiefe kommen, die einen direkten Einfluss auf die Genauigkeit des Bauprozesses hat. Beispielsweise wird bei einem Wert der Lasereindringtiefe, der die gewünschte Schichtstärke des Verfahrens übersteigt, über dieselbige ausgehärtet, so dass die Auflösung des Verfahrens sinkt. Hohe Werte der Lasereindringtiefe spielen insbesondere bei transparenten Stereolithographieharzen eine große Rolle, die vorzugsweise für die Produktion von so genannten Otoplastiken eingesetzt werden. Im Falle von Stereolithographieharzen aus dem Bereich der Medizintechnik, und insbesondere im Falle von Stereolithographieharzen für die Herstellung von o.g. Ohrpassstücken ist aber die Produktions- und dementsprechend die Passgenauigkeit des Formkörpers von herausragender Bedeutung.

### Beispiel 2:

| | |
|---|---|
| 27,4*(1-x/100) Gew.-% | aliphatisches Urethanacrylatoligomer (Viskosität < 15 Pa s und Molekülgewicht >1500) |
| 27,2*(1-x/100) Gew.-% | Bisphenol-A-ethoxylat(4)dimethacrylat |
| 12,8 *(1-x/100) Gew.-% | aliphatisches Urethantriacrylat |
| 10,5 *(1-x/100) Gew.-% | Bisphenol-A-ethoxylat(2)dimethacrylat |
| 5,7 *(1-x/100) Gew.-% | Tetrahydrofurfurylmethacrylat |
| 5,7 *(1-x/100) Gew.-% | Triethylenglykoldimethacrylat |
| 4,7 *(1-x/100) Ges.-% | Asymmetrische Variante des Umsetzungsproduktes von 2-Hydroxyethylmethacrylat mit dem HDI-Trimerisat |
| 3,3 *(1-x/100) Gew.-% | 7,7,9-(bzw.7,9,9-)Trimethyl-4,13-dioxo-3,14-dioxa-5,12-diaza-hexadecan-1,16-diol-dimethacrylat |
| 1,1 *(1-x/100) Gew.-% | 2,4,6-Trimethylbenzoyldiphenyl-phosphinoxid |
| 0,4 *(1-x/100) Gew.-% | Bis(2,4,6-trimethylbenzoyl)-phenylphosphinoxid |
| x-Gew.-% | anaerober Inhibitor |

Als anaerobe Inhibitoren wurden Phenothiazin (Abb.3 und 4) in den Konzentrationen x= 0; 0,025; 0,05; 0,1 und 0,15 Gew.-% und 2,2-Diphenyl-1-picrylhydrazyl-radikal (DPPH) (Abb.5 und 6) in den Konzentrationen x= 0; 0,01; 0,025; und 0,05 Gew.-%.

In Abbildung 3 ist der Einfluss der Konzentration von Phenothiazin auf die Lasereindringtiefe Dp der Harzformulierungen aus Beispiel 2 gezeigt.

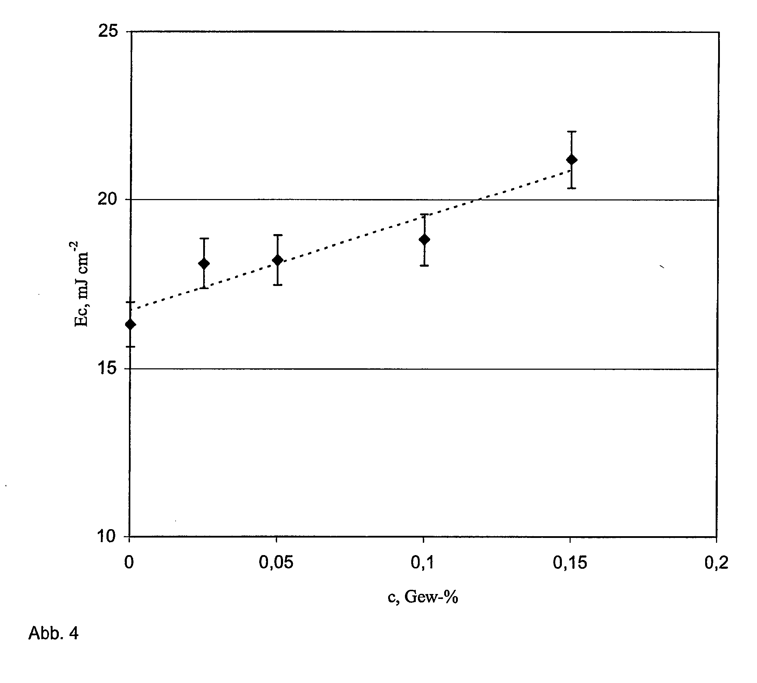

In Abbildung 4 ist der Einfluss der Konzentration von Phenothiazin auf die kritische Energie Ec der Harzformulierungen aus Beispiel 2 gezeigt.

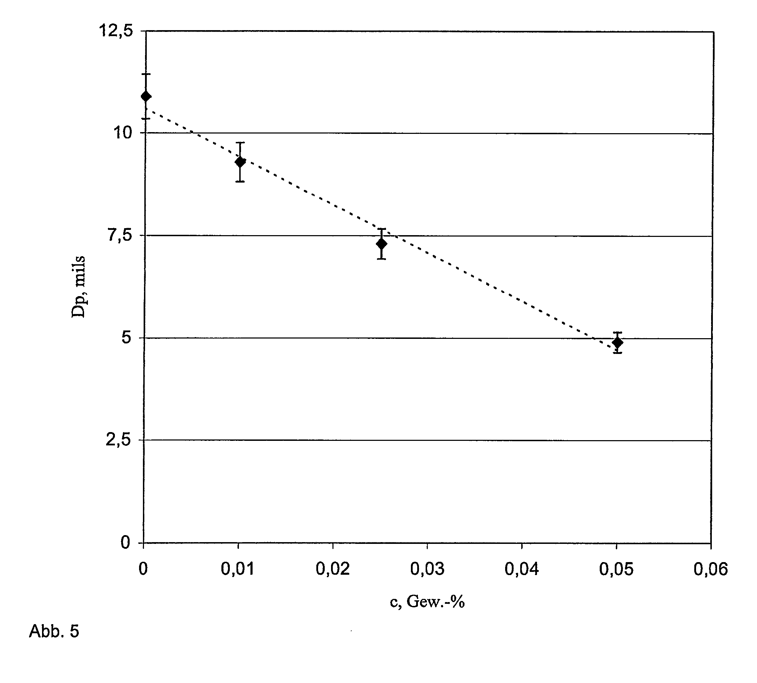

In Abbildung 5 ist der Einfluss der Konzentration von DPPH auf die Lasereindringtiefe Dp der Harzformulierungen aus Beispiel 2 gezeigt.

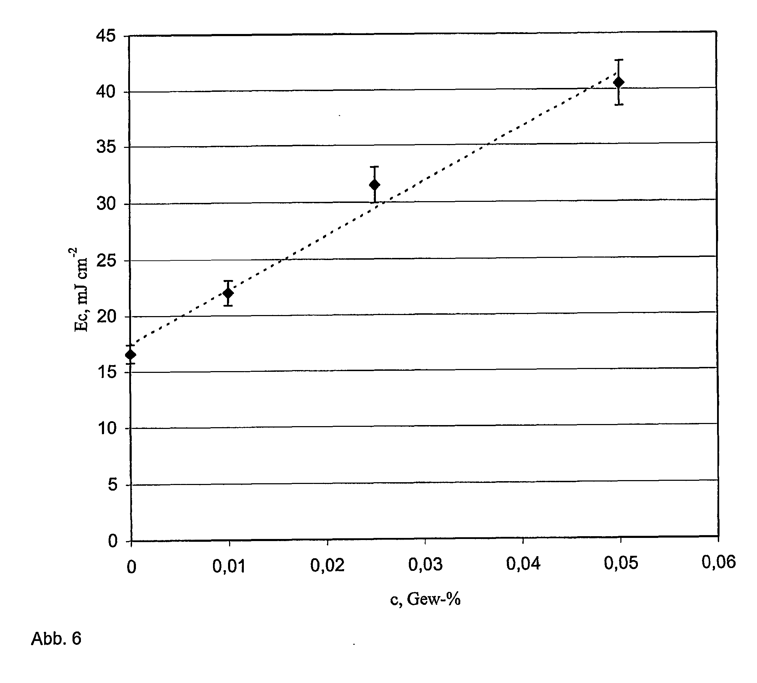

In Abbildung 6 ist der Einfluss der Konzentration von DPPH auf die kritische Energie Ec der Harzformulierungen aus Beispiel 2 gezeigt.

In Tab.1 ist der Einfluss der Inhibitorkonzentration auf die mechanischen Werte der Harzformulierung aus Beispiel 2 angegeben.

Der Einfluss der anaeroben Inhibitoren auf die Mechanik der Formkörper ist der Tab. 1 zu entnehmen. Die Bestimmung der Biegefestigkeiten, E-Module und Dehnungen wurde in Anlehnung an die EN ISO 178 (1996) mit einer Zwick 1-Testmaschine der Fa. Zwick durchgeführt. Die Prüfkörper wurden mit der Stroboskop-Belichtungseinheit PCU der Fa. Dreve 2x7min nachgehärtet. Der Tab.1 kann man entnehmen, dass insbesondere bei Zugabe des anaeroben Inhibitors Phenothiazin Harzformulierungen erhalten werden, die denen dem Stand der Technik (siehe Tab. 3 und Tab.4) in der Gesamtheit ihrer mechanischen Werte überlegen sind.

Den erfindungsgemäßen Gemischen können, falls erforderlich, die dem Fachmann bekannten Additive zugesetzt werden, beispielsweise Verlaufsmittel, UV-Stabilisatoren, Benetzungsmittel, Füllstoffe, Farbstoffe und Pigmente. Im Sinne der Erfindung besonders geeignete Farbstoffe sind Anthrachinon-Farbstoff-Zubereitungen, wie sie z. B. von der Firma Bayer unter dem Namen Macrolex® verkauft werden.

### Verwendungsbeispiele

### Beispiel 3 eines gelblich opaken Stereolithographieharzes:

| | |
|---|---|
| 27,3 Gew.-% | aliphatisches Urethanacrylatoligomer (Viskosität < 15 Pa s und Molekülgewicht >1500) |
| 27,1 Gew.-% | Bisphenol-A-ethoxylat(4)dimethacrylat |
| 12,8 Gew.-% | aliphatisches Urethantriacrylat |
| 10,6 Gew.-% | Bisphenol-A-ethoxylat(2)dimethacrylat |
| 5,7 Gew.-% | Tetrahydrofurfurylmethacrylat |
| 5,7 Gew.-% | Triethylenglykoldimethacrylat |
| 4,7 Gew.-% | Asymmetrische Variante des Umsetzungsproduktes von 2-Hydroxyethylmethacrylat mit dem HDI-Trimerisat |
| 3,4 Gew.-% | 7,7,9-(bzw. 7,9,9-)Trimethyl-4,13-dioxo-3,14-dioxa-5,12-diaza-hexadecan-1,16-diol-dimethacrylat |
| 1,1 Gew.-% | 2,4,6-Trimethylbenzoyldiphenyl-phosphinoxid |
| 0,8 Gew.-% | pyrogene Kieselsäure (Primärpartikelgröße < 16 nm) |
| 0,4 Gew.-% | Bis(2,4,6-trimethylbenzoyl)-phenylphosphinoxid |
| 0,4 Gew.-% | Eisenoxidpigment |

### Beispiel 4 eines blautransparenten Stereolithographieharzes:

| | |
|---|---|
| 27,67 Gew.-% | aliphatisches Urethanacrylatoligomer (Viskosität < 15 Pa s und Molekülgewicht >1500) |
| 27,5 Gew.-% | Bisphenol-A-ethoxylat(4)dimethacrylat |
| 13,0 Gew.-% | aliphatisches Urethantriacrylat |
| 10,7 Gew.-% | Bisphenol-A-ethoxylat(2)dimethacrylat |
| 5,7 Gew.-% | Tetrahydrofurfurylmethacrylat |
| 5,7 Gew.-% | Triethylenglykoldimethacrylat |
| 4,8 Gew.-% | Asymmetrische Variante des Umsetzungsproduktes von 2-Hydroxyethylmethacrylat mit dem HDI-Trimerisat |
| 3,4 Gew.-% | 7,7,9-(bzw. 7,9,9-)Trimethyl-4,13-dioxo-3,14-dioxa-5,12diaza-hexadecan-1,16-diol-dimethacrylat |
| 1,1 Gew.-% | 2,4,6-Trimethylbenzoyldiphenyl-phosphinoxid |
| 0,4 Gew.-% | Bis(2,4,6-trimethylbenzoyl)-phenylphosphinoxid |
| 0,03 Gew.-% | Anthrachinon-Farbstoff-Zubereitung (inkl. C. I. Solvent Blue 97) |

### Beispiel 5 eines rottransparenten Stereolithographieharzes:

| | |
|---|---|
| 27,69 Gew.-% | aliphatisches Urethanacrylatoligomer (Viskosität < 15 Pa s und Molekülgewicht >1500) |
| 27,5 Gew.-% | Bisphenol-A-ethoxylat(4)dimethacrylat |
| 13,0 Gew.-% | aliphatisches Urethantriacrylat |
| 10,7 Gew.-% | Bisphenol-A-ethoxylat(2)dimethacrylat |
| 5,7 Gew.-% | Tetrahydrofurfurylmethacrylat |
| 5,7 Gew.-% | Triethylenglykoldimethacrylat |
| 4,8 Gew.-% | Asymmetrische Variante des Umsetzungsproduktes von 2-Hydroxyethylmethacrylat mit dem HDI-Trimerisat |
| 3,4 Gew.-% | 7,7,9-(bzw. 7,9,9-)Trimethyl-4,13-dioxo-3,14-dioxa-5,12-diaza-hexadecan-1,16-diol-dimethacrylat |
| 1,1 Gew.-% | 2,4,6-Trimethylbenzoyldiphenyl-phosphinoxid |
| 0,4 Gew.-% | Bis(2,4,6-trimethylbenzoyl)-phenylphosphinoxid |
| 0,01 Gew.-% | Azofarbstoff Rot H |

### Beispiel 6 einer klartransparenten Harzformulierung für die Stereolithographie

| | |
|---|---|
| 27,7 Gew.-% | aliphatisches Urethanacrylatoligomer (Viskosität < 15 Pa s und Molekülgewicht >1500) |
| 27,5 Gew.-% | Bisphenol-A-ethoxylat(4)dimethacrylat |
| 13,0 Gew.-% | aliphatisches Urethantriacrylat |
| 10,7 Gew.-% | Bisphenol-A-ethoxylat(2)dimethacrylat |
| 5,7 Gew.-% | Tetrahydrofurfurylmethacrylat |
| 5,7 Gew.-% | Triethylenglykoldimethacrylat |
| 4,8 Gew.-% | Asymmetrische Variante des Umsetzungsproduktes von 2-Hydroxyethylmethacrylat mit dem HDI-Trimerisat |
| 3,4 Gew.-% | 7,7,9-(bzw.7,9,9-)Trimethyl-4,13-dioxo-3,14-dioxa-5,12diaza-hexadecan-1,16-diol-dimethacrylat |
| 1,1 Gew.-% | 2,4,6-Trimethylbenzoyldiphenyl-phosphinoxid |
| 0,4 Gew.-% | Bis(2,4,6-trimethylbenzoyl)-phenylphosphinoxid |

### Beispiel 7 einer klartransparenten Harzformulierung für die PNP-Technik

| | |
|---|---|
| 25,84 Gew.-% | Bisphenol-A-ethoxylat(4)dimethacrylat |
| 18,3 Gew.-% | aliphatisches Urethanacrylatoligomer (Viskosität < 15 Pa s und Molekülgewicht >1500) |
| 15,0 Gew.-% | 50% Lösung von Nanopartikeln (< 50 nm) in Hexandioldiacrylat |
| 11,6 Gew.-% | aliphatisches Urethantriacrylat |
| 9,3 Gew.-% | Bisphenol-A-ethoxylat(2)dimethacrylat |
| 5,7 Gew.-% | Tetrahydrofurfurylmethacrylat |
| 5,7 Gew.-% | Triethylenglykoldimethacrylat |
| 4,7 Ges.-% | Asymmetrische Variante des Umsetzungsproduktes von 2-Hydroxyethylmethacrylat mit dem HDI-Trimerisat |
| 3,3 Gew.-% | 7,7,9-(bzw.7,9,9-)Trimethyl-4,13-dioxo-3,14-dioxa-5,12diaza-hexadecan-1,16-diol-dimethacrylat |
| 0,5 Gew.-% | 2,4,6-Trimethylbenzoyldiphenyl-phosphinoxid |
| 0,06 Gew.-% | UV-Stabilisator |

Die für die Technik der Stereolithographie relevanten Parameter der o. g. Harze sind in Tab.2 aufgeführt. Sämtliche Viskositätsmessungen wurden bei 23°C mit einem CVO 120-Rheometer der Fa. Bohlin Instruments durchgeführt. Die Bestimmung der Biegefestigkeiten, E-Module und Dehnungen wurde in Anlehnung an die EN ISO 178 (1996) mit einer Zwick 1-Testmaschine der Fa. Zwick durchgeführt. Zur Ermittlung der Ec und Dp-Werte mittels der o. g. Windowpane-Methode wurden jeweils die Mittelwerte aus 10 Windowpane-Probekörpern ermittelt. Die Probekörper wurden mit einer Viper si2 SLA Anlage (Fa. 3D Systems), ausgerüstet mit einem Nd:YVO4 Festkörperlaser, hergestellt. Die Grünlinge wurden mit der Stroboskop-Belichtungseinheit Fototec PCU der Fa. Dreve 2x7min nachgehärtet.

Mit ausgehärteten Probekörpern der Stereolithographiharzformulierungen aus Bsp.3 wurden darüber hinaus Studien zum cytotoxischen Potential der Formulierung durchgeführt.

In der Testreihe zur Bestimmung der biologischen Reaktion der Säugetierzellkultur (L929) auf die Probekörper wurden Elutionstests gemäß ISO 10993-5 (1999), ISO 10993-12 (2002) und ISO 17025 (1999) durchgeführt. Man findet keine biologische Reaktivität (Grad 0) der L929 Säugetierzellen. Dementsprechend ist das o. g. Material nicht cytotoxisch und genügt den Vorgaben aus ISO 10993-5.

Aus diesen Ergebnissen wird deutlich, dass die erfindungsgemäßen Stereolithographieharzformulierungen im medizintechnischen Bereich, insbesondere für die Herstellung von Ohrstücken, einsetzbar sind.

In Tab. 3 sind die mechanischen und chemischen Parameter der kommerziell erhältlichen Stereolithographieharze LLS71410 der Fa. Vantico und des Fototec SL (rottransparent) der Fa. Dreve, welche für den medizintechnischen Einsatz konzipiert sind, aufgeführt. Der Tabelle kann man entnehmen, dass im Vergleich die erfindungsgemäßen Formulierungen im Vergleich zur Harzformulierung der Fa. Vantico vorteilhafterweise wesentlich geringere Viskositäten, höhere Biegefestigkeiten und E-Module besitzen. Im Vergleich zum Fototec SL-Material der Fa. Dreve liegen die Bruchdehnungen der offenbarten Formulierungen signifikant über den Werten für das kommerziell erhältliche Produkt. Darüber hinaus findet man, dass das Material der Fa. Vantico zwar als nicht cytotoxisch einzustufen ist, aber in Versuchsreihen zur Bestimmung der Cytotoxizität eine dem Grad 1 entsprechende, leichte biologische Reaktion induziert. Unter Berücksichtigung des Einsatzes im medizintechnischen Bereich ist dies bei den erfindungsgemäßen Formulierungen vorteilhafterweise nicht der Fall.

Alle erfindungsgemäßen Stereolithographieharzformulierungen aus den Bsp.3-7 weisen unter produktionstechnschen Gesichtspunkten ideale Viskositäten < 2000 mPa s.

Im Vergleich zu den in der konventionellen Technik (PNP-Verfahren) genutzten Materialien zur Herstellung von Ohrstücken (z.B. Fotoplast® der Fa. Dreve Otoplastik GmbH (siehe Tab.4)) sind die mechanischen Werte Biegefestigkeit und E-Modul der ausgehärteten Formkörper der in Bsp. 7 offenbarten Formulierung signifikant höher.

In Tab.2 sind die Parameter der Stereolithographieharzformulierungen aus Bsp.3 bis Bsp. 7 angegeben.

In Tab.3 sind die Daten zu kommerziell erhältlichen Stereolithographieharzen angegeben.

In Tab.4 sind die mechanischen Werte kommerziell erhältlicher Produkte für die Herstellung von Ohrstücken angegeben.

**Tab. 1:**

| **Inhibitor** | **Konz., Gew.-%** | **E-Modul, N mm⁻²** | **Biegefestigkeit, N mm⁻²** | **Bruchdehnung ,%** |
|---|---|---|---|---|
| - | - | 1762 | 89 | 9 |
| Phenothiazin | 0,025 | 1867 | 95 | 15 |
| Phenothiazin | 0,05 | 1989 | 95 | 13 |
| Phenothiazin | 0,10 | 2007 | 101 | 12 |
| Phenothiazin | 0,15 | 1832 | 89 | 10 |
| DPPH | 0,01 | 1452 | 61 | 13 |
| DPPH | 0,025 | 1324 | 69 | 11 |
| DPPH | 0,05 | 1277 | 66 | 10 |

**Tab. 2:**

| **Eigenschaft** | **Bsp.3** | **Bsp.4** | **Bp.5** | **Bsp.6** | **Bsp.7** |
|---|---|---|---|---|---|
| Viskosität bei 23°C, mPas | 1700 | 1800 | 1800 | 1800 | 1590 |
| E-Modul des ausgehärteten Formkörpers, N mm⁻² | 2107 | 2010 | 1926 | 1966 | 2227 |
| Biegefestigkeit des ausgehärteten Formkörpers, N mm⁻² | 103 | 105 | 103 | 104 | 114 |
| Bruchdehnung des ausgehärteten Formkörpers, % | 13 | 11 | 11 | 12 | 11 |
| Ec, mJ cm⁻² | 13,0 | 12,5 | 13,2 | 12,1 | n.b. |
| Dp, mils | 5,1 | 9,5 | 9,4 | 9,8 | n.b. |

**Tab. 3:**

| **Eigenschaft** | **Stereolithographieharz Fototec SL (rottransp.) der Fa. Dreve** | **Stereolithographieharz LLS71410 der Fa. Vantico** |
|---|---|---|
| Viskosität bei 23°C, mPa s | 820 | 2350 |
| E-Modul, N mm⁻² | 2004 | 1612 |
| Biegefestigkeit, N mm⁻² | 98 | 81 |
| Bruchdehnung, % | 7 | 12 |
| Ec, mJ cm⁻² | 4,6 | 3,4 |
| Dp, mils | 15 | 6,6 |

**Tab. 4:**

| **Material** | **E-Modul, N mm⁻²** | **Biegefestigkeit, N mm⁻²** | **Bruchdehnung ,%** |
|---|---|---|---|
| Fotoplast S/IO blau transparent, Lot. 201504 | 1513 | 81 | 10 |
| Fotoplast S/IO rot transparent, Lot. 301531 | 1527 | 84 | 13 |
| Fotoplast S/IO farblos transparent, Lot. 203523 | 1602 | 88 | 11 |
| Fotoplast S/IO gelblich, Lot. 301515 | 1586 | 80 | 13 |

## Patentansprüche

1. Biokompatible, niedrigviskose, strahlungshärtbare Formulierung, zur Herstellung von Ohrstücken mittels PNP bzw. Stereolithographieverfahren, enthaltend:
a) 15-60 Gew.-% eines monomeren oder oligomeren Dimethacrylats auf Basis von Bisphenol A oder Bisphenol F
b) 0-50 Gew.-% eines oder mehrerer monomerer/oligomerer Urethan(meth)acrylate mit einer Funktionalität von n < 4 , einer Viskosität < 30 Pa s und einem Molekülgewicht < 3500
c) 2-25 Gew.-% eines monomeren aliphatischen oder cycloaliphatischen Dimethacrylats mit einer viskosität < 3 Pa s
d) 2-35 Gew.-% eines Iminooxadiazondionderivates, charakterisiert durch 3 Methacrylat- und/oder Acrylatfunktionen
e) 0-15 Gew.-% eines oder mehrer monofunktioneller Methacrylate
f) 0,5-6 Gew.-% eines oder einer Kombination mehrerer Photoinitiatoren, deren Absorption im Wellenlängenbereich des eingesetzten Laserstrahles bzw. der Bestrahlungsquelle liegt
g) 0 -0,5 Gew.-% eines oder mehrerer anaerober Inhibitoren
h) 0-40 Gew.-% an Füllstoffen mit einer Partikelgröße < 25 µm
i) 0-5 Gew.-% an Farbmitteln
j) 0-5 Gew.-% an üblichen Additiven wie UV-Stabilisatoren oder Verlaufsadditiven, wobei der Anteil der Komponenten a) bis j) zusammen 100 Gew.-% beträgt.

2. Formulierung nach Anspruch 1, wobei das Gemisch enthält:
a) 20-50 Gew.-% eines n-fach ethoxylierten Bisphenol-A-Dimethacrylats mit einem Ethoxylierungsgrad von n < 10 oder eine Mischung n-fach ethoxylierter Bisphenol-A-Dimethacrylate mit einem Ethoxylierungsgrad von n < 10
b) 5-45 Gew.-% eines oder mehrerer aliphatischer oder cycloaliphatischer monomerer/oligomerer Urethan(meth)acrylate mit einer Funktionalität von n < 4 und einer Viskosität < 15 Pa s und einem Molekülgewicht < 2000
c) 3-10 Gew.-% eines monomeren aliphatischen oder cycloaliphatischen Dimethacrylats mit einer Viskosität < 3 Pa s
d) 3-25 Gew.-% eines Iminooxadiazondionderivates, charakterisiert durch 3 Methacrylat- und/oder Acrylatfunktionen
e) 2-15 Gew.-% eines oder mehrer monofunktioneller Methacrylate mit einer Viskosität < 3 Pa s
f) 1-4 Gew.-% eines oder einer Kombination mehrerer Photoinitiatoren, deren Absorption im Wellenlängenbereich des eingesetzten Laserstrahles bzw. der Bestrahlungsquelle liegt
g) 0-0,5 Gew.-% eines oder einer Kombination von anaeroben Inhibitoren, auch in Verbindung mit denen, dem Stereolithographiefachmann bekannten aeroben Inhibitoren
h) 0-20 Gew.-% an Füllstoffen mit einer Partikelgröße < 80 nm
i) 0-5 Gew.-% an Farbmitteln
j) 0,01-3 Gew.-% an üblichen Additiven wie UV-Stabilisatoren oder Verlaufsadditiven, wobei der Anteil der Komponenten a) bis j) zusammen 100 Gew.-% beträgt.

3. Verwendung einer Formulierung nach einem der Ansprüche 1 oder 2 zur Herstellung von medizintechnischen Produkten, insbesondere Ohrpassstücken, Otoplastiken, Schalen für im Ohr getragene Hörgeräte oder Ohrstücken.

## Claims

1. A biocompatible, low-viscous, radiation-curable formulation for producing ear pieces by means of PNP methods or stereolithographic methods, said formulation comprising:
a) 15 - 60 wt.% of a monomeric or oligomeric dimethacrylate based on bisphenol A or bisphenol F;
b) 0 - 50 wt.% of one or more monomeric or oligomeric urethane (meth)acrylates with a functionality n < 4, a viscosity < 30 Pa·s and a molecular weight < 3,500;
c) 2 - 25 wt.% of a monomeric aliphatic or cycloaliphatic dimethacrylate with a viscosity < 3 Pa·s;
d) 2 - 35 wt.% of an iminooxadiazone dion derivative, **characterized by** 3 methacrylate and/or acrylate functions;
e) 0 - 15 wt.% of one or more monofunctional methacrylates;
f) 0.5 - 6 wt.% of a photo initiator or a combination of photo initiators, whose absorption lies in the wavelength range of the laser beam that is used or of the irradiation source;
g) 0 - 0.5 wt.% of one or more anaerobic inhibitors;
h) 0 - 40 wt.% of fillers with a particle size < 25 µm;
i) 0 - 5 wt.% of colorants;
j) 0 - 5 wt.% of conventional additives such as UV stabilizers or process additives, wherein the sum of the fractions of the components a) to j) totals 100 wt.%.

2. The formulation according to claim 1, the mixture comprising:
a) 20 - 50 wt.% of a bisphenol A dimethacrylate ethoxylated n times with an ethoxylation degree of n < 10 or a mixture of bisphenol A dimethacrylates ethoxylated n times with an ethoxylation degree of n < 10;
b) 5 - 45 wt.% of one or more aliphatic or cycloaliphatic monomeric/oligomeric urethane (meth)acrylates with a functionality n < 4, a viscosity < 15 Pa·s and a molecular weight < 2,000;
c) 3 - 10 wt.% of a monomeric aliphatic or cycloaliphatic dimethacrylate with a viscosity < 3 Pa·s;
d) 3 - 25 wt.% of an iminooxadiazone dion derivative, **characterized by** 3 methacrylate and/or acrylate functions;
e) 2 - 15 wit.% of one or more monofunctional methacrylates with a viscosity < 3 Pa·s;
f) 1 - 4 wt.% of a photo initiator or a combination of photo initiators, whose absorption lies in the wavelength range of the laser beam that is used or of the irradiation source;
g) 0 - 0.5 wt.% of an anaerobic inhibitor or a combination of anaerobic inhibitors, also in connection with the anaerobic inhibitors known to the man skilled in the art of stereolithography;
h) 0 - 20 wt.% of fillers with a particle size < 80 nm;
i) 0 - 5 wt.% of colorants;
j) 0.01 - 3 wt.% of conventional additives such as UV stabilizers or process additives, wherein the sum of the fractions of the components a) to j) totals 100 wt.%.

3. The use of a formulation according to one of claims 1 or 2 for producing medical products, in particular adaptive ear pieces, otoplastic parts, shells for hearing aids worn in the ear or ear pieces.

## Revendications

1. formulation radiodurcissable biocompatible à faible viscosité pour fabriquer des parties d'appareils auditifs au moyen de procédés PNP ou de la stéréolithographie, contenant:
a) 15 à 60 % en poids d'un diméthacrylate monomère ou oligomère à base de bisphénol A ou de bisphénol F;
b) 0 à 50 % en poids d'un ou plusieurs (méth)acrylates d'uréthane monomères ou oligomères ayant une fonctionnalité n < 4, une viscosité < 30 Pa·s et un poids moléculaire < 3500;
c) 2 à 25 % en poids d'un diméthacrylate monomère aliphatique ou cyclo-aliphatique ayant une viscosité < 3 Pa·s;
d) 2 à 35 en poids d'un dérivé d'imino oxadiazone dione, **caractérisé par** 3 fonctions de méthacrylate et/ou acrylate;
e) 0 à 15 % en poids d'un ou plusieurs méthacrylates monofonctionnels;
f) 0,5 à 6 % en poids d'un ou d'une combinaison de plusieurs photoamorceurs dont l'absorption se situe dans la plage de longueurs d'ondes du faisceau laser utilisé ou de la source d'irradiation,
g) 0 à 0,5 % en poids d'un ou plusieurs inhibiteurs anérobies;
h) 0 - 40 % en poids de matières de remplissage ayant une taille de particules < 25 µm;
i) 0 - 5 % en poids de colorants;
j) 0 à 5 % en poids d'additifs usuels tels que des agents de stabilisation aux UV ou des additifs de nivelage, la somme des composants a) à j) étant égale à 100 % en poids.

2. Formulation selon la revendication 1, le mélange contenant:
a) 20 à 50 % en poids d'un diméthacrylate de bisphénol A éthoxylé n fois, ayant un degré d'éthoxylation n < 10, ou d'un mélange de diméthacrylates de bisphénol A éthoxylés n fois, ayant un degré d'éthoxylation n < 10;
b) 5 à 45 % en poids d'un ou plusieurs (méth)acrylates d'uréthane monomères ou oligomères ayant une fonctionnalité n < 4, une viscosité < 15 Pa·s et un poids moléculaire < 2000;
c) 3 à 10 % en poids d'un méthacrylate aliphatique ou cyclo-aliphatique ayant une viscosité < 3 Pa·s;
d) 3 à 25 en poids d'un dérivé d'imino oxadiazone dione, **caractérisé par** 3 fonctions de méthacrylate et/ou acrylate;
e) 2 à 15 % en poids d'un ou plusieurs méthacrylates monofonctionnels ayant une viscosité < 3 Pa·s;
f) 1 à 4 % en poids d'un ou d'une combinaison de plusieurs photoamorceurs dont l'absorption se situe dans la plage de longueurs d'ondes du faisceau laser utilisé ou de la source d'irradiation;
g) 0 à 0,5 % en poids d'un inhibiteur anérobie ou d'une combinaison d'inhibiteurs anérobies, aussi associés à des inhibiteurs anérobies connus à l'homme du métier de la stéréolithographie;
h) 0 à 20 % en poids de matières de remplissage ayant une taille de particules < 80 nm;
i) 0 - 5 % en poids de colorants;
j) 0,01 - 3 % en poids d'additifs usuels tels que des agents de stabilisation aux UV ou des additifs de nivelage, la somme des composants a) à j) étant égale à 100 % en poids.

3. Utilisation d'une formulation selon une des revendications 1 ou 2 pour fabriquer des produits médicaux, en particulier des parties d'appareils auditifs adaptifs, pièces otoplastiques, coques pour des aides auditives portées dans l'oreille ou écouteurs.
